# EUROPEAN PATENT APPLICATION

(11) **EP 1 995 533 A2**
(43) Date of publication of application: **26.11.2008**
(21) Application number: 08008994.9
(22) Date of filing: 15.05.2008
(51) Int. Cl.: F24H 9/20

(54) **A boiler monitoring device**

(30) Priority: 24.05.2007 GB 0709975
(71) Applicant: Can-Du Limited, Ballynahinch BT24 8UH (GB)
(72) Inventor: Simpson, Terence, Ballynahinch, BT24 8UH Northern Ireland (GB)
(74) Representative: Waller, Stephen

(57) **Abstract**

A device (10) for monitoring a boiler, the device comprising means for detecting when the boiler is in use, and means for determining fuel usage based on the detected boiler use. The determining means determines fuel usage based on the length of time for which the boiler is in use and a parameter indicative of the rate of consumption of fuel by the boiler when in use.

## Description

### FIELD OF THE INVENTION

The present invention relates to monitoring devices and in particular to devices for monitoring boilers.

### BACKGROUND TO THE INVENTION

Conventional heating systems are usually supplied with fuel, usually oil, from a local fuel tank which needs to be replenished periodically depending on usage. The fuel tank may have a gauge that allows a user to see how much fuel is in the tank and so to know when to order more fuel. However, this relies on the user being proactive and often results in fuel running out.

It is known to install a fuel monitoring device in the fuel tank which monitors the level of oil in the tank and transmits corresponding data to a remote unit, typically inside a building. The remote unit is more readily monitored by the user than an external fuel gauge and may also generate an alarm signal when fuel is running low. In some cases, the remote unit may even contact a fuel supplier to arrange for the delivery of fuel. Such systems are generally effective, but they are expensive.

It would be desirable to mitigate the problems outlined above.

### SUMMARY OF THE INVENTION

In the context of the present invention, the term "boiler" is intended to embrace any appliance which consumes fuel, typically oil or gas, to heat a heating medium, typically water or steam. The heated medium is then typically circulated around a heating system, e.g. a domestic heating system comprising one or more radiators.

Accordingly, from a first aspect, the invention provides a device for monitoring a boiler, the device comprising means for detecting when the boiler is in use, and means for determining fuel usage based on the detected boiler use. Preferably the determining means determines fuel usage based on the length of time for which the boiler is in use and a parameter indicative of the rate of consumption of fuel by the boiler when in use.

In the preferred embodiment, said detecting means comprises a vibration monitor. The vibration monitor may be adapted for detecting vibrations of the boiler, or any associated component, during use and may, for example, comprise a piezo-electric sensor and/or an accelerometer. The vibration monitor may alternately comprise a microphone and may, for example, be adapted to detect audio signals, or sound, produced by the boiler, or any associated component, during use.

The device may be associated with a remote unit to which data concerning fuel usage may be sent, for example via wireless link. The remote unit may generate an alarm if the estimated fuel reserve drops below a preset threshold.

From a second aspect, the invention provides a boiler monitoring system comprising a boiler and the device of the first aspect of the invention. Typically, the device is mounted on the boiler, e.g. on its outer casing, although it may alternatively be mounted on other associated components such as a pipes or radiator. In alternative embodiments (for example where a microphone is used as the detector), the device may be provided separately from the boiler.

From a third aspect, the invention provides a method of monitoring boiler usage, the method comprising detecting when the boiler is in use, and determining fuel usage based on the detected boiler use.

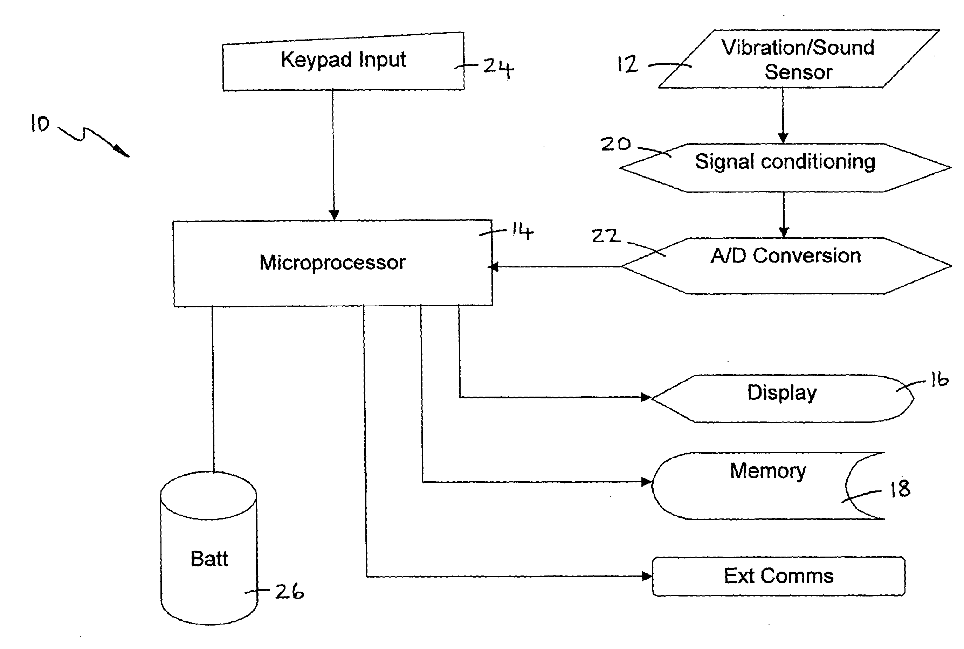

Further advantageous aspects of the invention will become apparent to those ordinarily skilled in the art upon review of the following description of a specific embodiment of the invention and with reference to the accompanying drawing.

### BRIEF DESCRIPTION OF THE DRAWING

An embodiment of the invention is now described, by way of example and with reference to the accompanying drawing which is a schematic view of a boiler monitoring device embodying the invention.

### DETAILED DESCRIPTION OF THE DRAWING

Referring now to the drawing, there is shown, generally indicated as 10, a boiler monitoring device embodying the invention. The device 10 includes means for detecting when the boiler is in use. In preferred embodiments, this involves detecting vibrations emanating from the boiler, or any other component, e.g. a pipe or radiator, associated therewith, during use. In such embodiments, the detecting means takes the form of a vibration or sound sensor 12.

In some embodiments, the vibration sensor 12 is capable of detecting physical vibrations of the boiler itself and, to this end, may be mounted, in use, on the boiler, e.g. on the boiler casing, or on any other component that is connected to the boiler from which said vibrations may be detected. More generally, the sensor 12 may be mounted anywhere it is able to detect vibrations caused by operation of the boiler. To this end, the device may include, or be co-operable with means for coupling it to a desired component. The coupling means could for example take the form of a magnetised support, or a clip or an adhesive base. The senor 12 may, for example, comprise an accelerometer, a piezo-electric sensor, or other transducer, which converts vibrations into corresponding electrical signals.

In other embodiments, the vibration sensor 12 is adapted to detecting audio signals or sound generated by the boiler, or by any associated component, when the boiler is in use. To this end, the sensor 12 may comprise a microphone, or similar transducer. In such embodiments, the sensor 12 may be mounted on the boiler, or any associated component, or may be provided separately, i.e. not mounted on the boiler or associated components. It is preferred, however, that the sensor is provided in close proximity with the boiler.

The device 10 further includes means for determining, or assessing, fuel usage based on the detected boiler use. Conveniently, the measurement means comprises a computer or processing unit 14, e.g. a microprocessor or microcontroller, running, in use, suitable computer program code.

The processing unit 14 may be arranged to determine or monitor fuel usage based on the length of time for which the boiler is in use. Hence, the processor 14 records the amount of time that the sensor 12 indicates that the boiler is in use. The processor 14 has access to, or is programmable with, a first parameter whose value is indicative of an initial quantity of fuel, e.g. the amount of fuel in an associated fuel tank after a fill or after a measurement. The processor 14 also has access to, or is programmable with, a second parameter whose value is indicative of the rate at which the boiler uses the fuel. The processor 14 may readily be programmed to estimate the quantity of fuel that remains in the tank using the first and second parameters and the detected boiler usage time.

The processor 14 may be programmed to raise an alarm in the event that the estimated quantity of remaining fuel falls below a threshold. The threshold may be programmable and available to the processor 14 as a third parameter.

The processing unit 14 is preferably associated with a user interface, for example a display unit 16, by which information concerning fuel usage may be conveyed to a user. The processing unit may also be associated with memory 18 for storing, for example, operating parameters, recorded data from the sensor and/or any computer program code.

Typically, the electrical signals generated by the sensor 12 would require some conventional signal processing or conditioning before being communicated to the processing unit 14 and so, advantageously, a signal conditioning unit 20 is provided. Moreover, the signals generated by the sensor 12 are typically analogue and so an analogue-to-digital converter 22 is provided to communicate the (conditioned) sensor output to the processing unit 14. The converter 22 may be provided separately, or may be included in the processing unit 14 itself.

A keypad 24 may be provided to allow a user to operate the device 10, e.g. set operating parameters and other operating preferences.

The device 10, or at least the portion of it located at the boiler, may be powered by a battery 26, although mains or generator supply may be employed if convenient.

The entire device 10 may be located at the site of the boiler, e.g. on the boiler itself. Alternatively, at least the display unit 16, or other interface, is may be located remotely from the sensor 12, e.g. in a building such as a domestic home or commercial premises. The processing unit 14 and associated circuitry (e.g. the memory 18 and the keypad 24) may also be located remotely from the sensor 12, e.g. in a building such as a domestic home or commercial premises, to provide it with a less harsh operating environment. Remote components of the device 10 may communicate with one another by any suitable conventional means, e.g. hardwired or wireless connection, as is convenient.

In the preferred embodiment, the processing unit 14 may be calibrated by, for example, the setting of one or more operating parameters whose values are indicative of the level of, or other characteristic(s) of, vibration (e.g. sound or physical component vibration) required to determine that the boiler is running. Optionally, one or more further calibration parameters may be provided for indicating the level or characteristics of vibration that are indicative of the boiler being off. Conveniently, these parameters relate to one or more characteristics of the signals emanating from the sensor 12. Hence, the processing unit 14 is able to interpret the sensor output.

Preferably, the processing unit 14 includes, or has access to, a clock, preferably with calendar functionality.

In the preferred embodiment, the processing unit 14 is programmed to calculate one or more of the following system characteristics: overall boiler run time since installation; run time per day (at least over a number of, e.g. 7, preceding days); and/or percentage run time since installation; percentage run time per day (at least over a number of, e.g. 7, preceding days). Some or all of this information may be displayed to the user.

Optionally, the processing unit 14 is programmable with one or more of the following operating parameters: a service parameter, indicating the desired or recommended operating time between boiler services; a fuel parameter, indicating the rate at which the boiler uses fuel; a service alarm parameter, indicating a period of time in advance of a service at which an alarm is generated; and/or a fuel alarm parameter, indicating a period of time in advance of the time at which it is estimated that the fuel in the tank will drop below a pre-set threshold at which an alarm is generated. These parameters may be set by the user and stored, for example, in the memory 18 for use by the processing unit 14.

The processing unit 14 may calculate, and optionally present to the user, the following system characteristics: estimated time before the fuel in the tank drops below the pre-set threshold (e.g. empty) - this could for example be calculated from the estimated amount of fuel left and a calculated rate of fuel use (e.g. a calculated daily usage rate based on the recorded boiler operation history over a number of days); and/or estimated period until the next service is due (which again may be based on a calculated daily usage rate).

The processing unit 14 may be programmed to cause one or more of the following outputs: an alarm when the estimated amount of fuel in the tank drops below the pre-set threshold; an alarm when the condition set be the fuel alarm parameter is satisfied; an alarm when a service is due; and/or an alarm when the condition set by the service alarm parameter is set.

In alternative embodiments, the device may detect when the boiler is operating by means other than detecting vibrations. For example, the device may be connected to or coupled to the electrical system that controls the boiler's operation and include means for determining from said electrical system when the boiler is in use.

In use, devices embodying the invention are typically mounted on or near, or installed on, a boiler that forms part of a central heating system.

The invention is not limited to the embodiment(s) described herein but can be amended or modified without departing from the scope of the present invention.

## Claims

1. A device (10) for monitoring a boiler, the device comprising means for detecting when the boiler is in use, and means for determining fuel usage based on the detected boiler use.

2. A device (10) as claimed in claim 1, wherein the determining means determines fuel usage based on the length of time for which the boiler is in use and a parameter indicative of the rate of consumption of fuel by the boiler when in use.

3. A device (10) as claimed in claim 1 or claim 2, wherein said detecting means comprises a vibration monitor (12) for detecting vibration produced by the boiler, or any associated component, during use.

4. A device (10) as claimed in claim 3, wherein said vibration monitor (12) comprises a piezo-electric sensor and/or an accelerometer.

5. A device (10) as claimed in claim 1 or claim 2, wherein said detecting means comprises a microphone adapted to detect audio signals, or sound, produced by the boiler, or any associated component, during use.

6. A device (10) as claimed in any preceding claim, wherein the device includes a processing unit (14) for determining fuel usage based upon the detected boiler use and for generating an alarm signal if estimated fuel reserve, based upon the determined fuel usage and on a parameter indicating an initial fuel quantity, drops below a preset threshold.

7. A device (10) as claimed in any preceding claim, wherein the processing unit (14) comprising a user interface (24) whereby the processing unit (14) can be programmed with a first parameter indicative of the rate of use of fuel by the boiler and a second parameter indicative of the initial volume of fuel.

8. A boiler monitoring system comprising a boiler and a device as claimed in any preceding claim.

9. A method of monitoring boiler usage, the method comprising detecting when the boiler is in use, and determining fuel usage based on the detected boiler use.

10. A method as claimed in claim 9, wherein the fuel usage of the boiler is determined based upon the detected time the boiler is in use and a parameter indicative of the rate of consumption of fuel by the boiler when in use.
